# EUROPEAN PATENT APPLICATION

(11) **EP 2 009 752 A1**
(43) Date of publication of application: **31.12.2008**
(21) Application number: 07740961.3
(22) Date of filing: 04.04.2007
(51) Int. Cl.: H01S 5/022, G02B 6/42

(54) **ELECTROOPTIC CONVERSION MODULE**

(30) Priority: 20.04.2006 JP 2006116765
(71) Applicant: Mitsumi Electric Co., Ltd., Tama-shi, Tokyo 206-8567 (JP)
(72) Inventor: ONO, Tadashi, Tama-shi, Tokyo 206-8567 (JP); ISHIKAWA, Yoshihiro, Tama-shi, Tokyo 206-8567 (JP); USUI, Takashi, Tama-shi, Tokyo 206-8567 (JP); ASANO, Shinichi, Tama-shi, Tokyo 206-8567 (JP)
(74) Representative: Grünecker, Kinkeldey, Stockmair & Schwanhäusser Anwaltssozietät
(86) International application number: PCT/JP2007/057525
(87) International publication number: WO 2007/122993

(57) **Abstract**

Provided is an electrooptic conversion module, which can replace electronic parts more economically in case a malfunction occurs or in case an improvement is needed. In the electrooptic conversion module (1), a plurality of split units such as an optical signal transmit/receive unit (201) for converting an electric signal inputted into an optical signal to output the converted signal to the optical waveguide (2), an amplifying unit (202) and a communication control unit (203) are so fitted and retained in a fitting unit (120) to be connected with a cover member (111) exposed to the outside, that the terminal portions in the fitting portion (120) and the electrode portions of those split units contact with each other.

## Description

### Technical Field

The present invention relates to an electric-optic conversion module.

### Background Art

Conventionally, an electric-optic conversion module using a planar lightwave circuit (PLC) has been known in optical communications such as FTTH (Fiber To The Home). In the electric-optic conversion module, a VCSEL (Vertical-Cavity Surface-Emitting Laser), a laser diode (LD), a photo diode (PD), and various LSIs (Large Scale Integration) containing a driver for driving a photonic device such as a laser diode or containing an amplifier for amplifying a signal are disposed on a PLC substrate.

For example, a Non-Patent Document 1 discloses a hybrid integration technique as a technique in the electric-optic conversion module. In the hybrid integration technique, positions between an optical waveguide and semiconductor optical elements such as a laser diode and a photo diode are adjusted on a silica-based PLC substrate with high accuracy to achieve an optical connection.
Non-Patent Document 1: Yuji Akahori, Ikuo Ogawa, Toshikazu Hashimoto, Takaharu Ohyama, Takuya Tanaka, Takeshi Kurosaki, and Yuichi Tohmori: NTT R&D, Vol.50, No.4, pp.294-302, 2001.

### Disclosure of Invention

### Problem to be Solved by the Invention

In the conventional electric-optic conversion module, however, the VCSEL, the PD, the amplifier, and the driver are integrally mounted on the substrate in a combination of user specifications. When replacing one of the elements, the whole substrate should be replaced. This causes extra costs. For example, when replacing only a PD with new one, the whole substrate, on which the normally operating amplifier and driver are mounted, should be replaced. When replacing the driver with new one in order to drive the semiconductor optical elements at a higher speed, the whole substrate, on which the normally operating VCSEL and PD are mounted, should be replaced. This is not economical.

In view of the foregoing, it is an object of the present invention to provide an electric-optic conversion module in which electronic components can be replaced at less cost.

### Means for Solving the Problem

In order to solve the above-described problem, according to the present invention, there is provided an electric-optic conversion module including: a functional section including an optoelectric conversion element and an auxiliary element of the optoelectric conversion element; and a connector which accommodates the functional section to electrically connect the functional section and an external device, wherein the functional section includes a plurality of divided units which are divided from one another according to functions or combination of the respective functions and which are removable from one another and removable from the connector.

Each of the plurality of divided units is accommodated in the connector through a positioning section for defining an accommodation position of each of the divided units in the connector.

The positioning section is formed by combination of a projection portion and a recessed portion, the projection portion being provided in an accommodation section of the connector and projecting toward a direction opposite to a fitting direction of the divided units, each of the divided units being provided with the recessed portion on a boundary surface with the adj acent divided unit, the projection portion being fitted into the recessed portion.

The projection portion is a conductive pin having a columnar shape, and the recessed portion is provided with a conductive portion which is in electrically contact with the conductive pin.

The projection portion is a conductive bump, and the recessed portion is provided with a conductive portion which is in electrically contact with the conductive pin.

The positioning section is formed by combination of a projection portion and a recessed portion, the projection portion and the recessed portion being respectively provided on faces, which are opposed to one another, of the adjacent divided units accommodated in the connector, the projection portion and the recessed portion being fitted into one another.

The projection portion and the recessed portion are respectively provided with different conductive portions which are in electrically contact with one another.

The connector is provided with conductive connecting terminals which are extended outward and which are in electrically contact with the divided units, and the divided units are electrically connected to one another by electrically connecting the connecting terminals.

An optical waveguide is optically connected to the optoelectric conversion element of the functional section.

### Effect of the Invention

According to the present invention, a plurality of divided units, which are divided from one another according to functions or combination of the respective functions and which constitute a functional section having an optoelectric conversion element and an auxiliary element thereof, are removable from a connector which accommodates the divided units to electrically connect the divided units and an external device. With this structure, in replacing a part of electronic components such as the optoelectric conversion elements or the auxiliary elements, it is only necessary to replace the divided unit including the element. Therefore, it is possible to replace the electronic component at less cost.

### Brief Description of Drawings

Fig. 1A is a schematic diagram illustrating a connection between electric-optic conversion modules through an optical waveguide.
Fig. 1B is a schematic diagram illustrating a state in which a plurality of divided units are fitted in a connector of an electric-optic conversion module.
Fig. 2 is a schematic diagram showing an optical signal transmission and reception unit, an amplifying unit, and a communication control unit being fitted into a fitting section.
Fig. 3 is an external perspective view of the connector with a cover member lifted.
Fig. 4 is a top view of the connector with the cover member is lifted.
Fig. 5A is a top schematic diagram illustrating a connection among a plurality of divided units.
Fig. 5B is a side schematic diagram illustrating the connection among the plurality of divided units.
Fig. 5C is a bottom schematic diagram illustrating the connection among the plurality of divided units.
Fig. 6 is a schematic diagram illustrating a connection between the optical signal transmission and reception unit and the amplifying unit.
Fig. 7 is a schematic sectional view showing a state in which the optical signal transmission and reception unit is fitted into the fitting section.
Fig. 8A is a schematic diagram showing divided units being fitted into a fitting section of an electric-optic conversion module according to a first modification.
Fig. 8B is a schematic diagram illustrating a conductive bump provided in the fitting section.
Fig. 8C is an enlarged bottom schematic diagram of a connection portion between an optical signal transmission and reception unit and an amplifying unit.
Fig. 9 is a schematic diagram showing divided units being fitted into a fitting section of an electric-optic conversion module according to a second modification.
Fig. 10A is a schematic diagram showing divided units being fitted into a fitting section of an electric-optic conversion module according to a third modification.
Fig. 10B is a top view of an optical signal transmission and reception unit, an amplifying unit, and a communication control unit.
Fig. 10C is an enlarged perspective view illustrating a connection portion between the optical signal transmission and reception unit and the communication control unit.

### Best Mode for Carrying Out the Invention

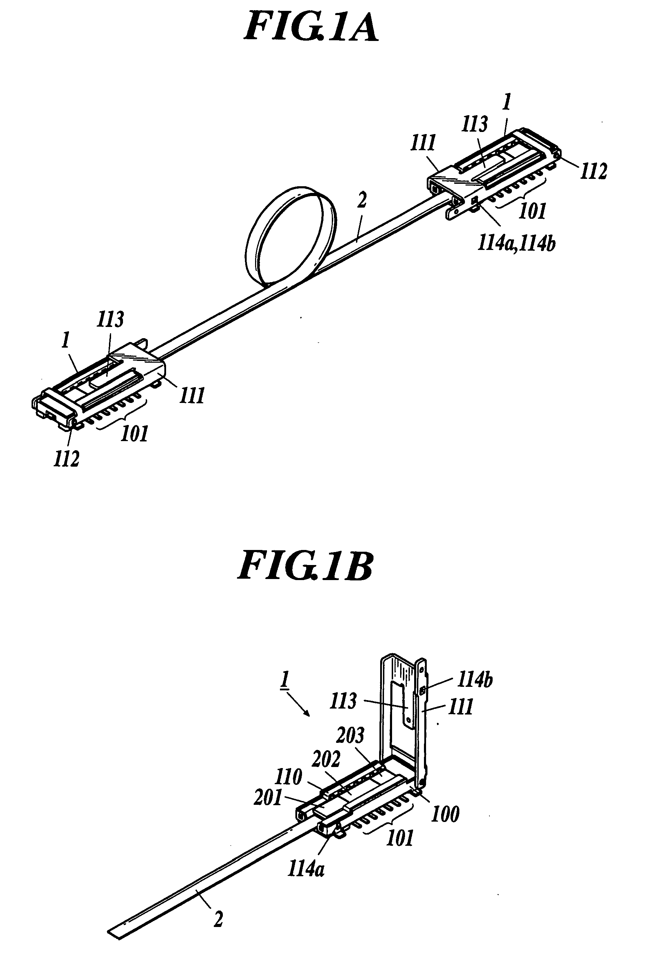

Embodiments of the present invention will be described below with reference to Fig. 1 to 10. The present invention is not limited to the embodiments. The Embodiments of the present invention show most preferred embodiments of the present invention. The wording of the invention and use of the invention are not limited to those of the embodiments.

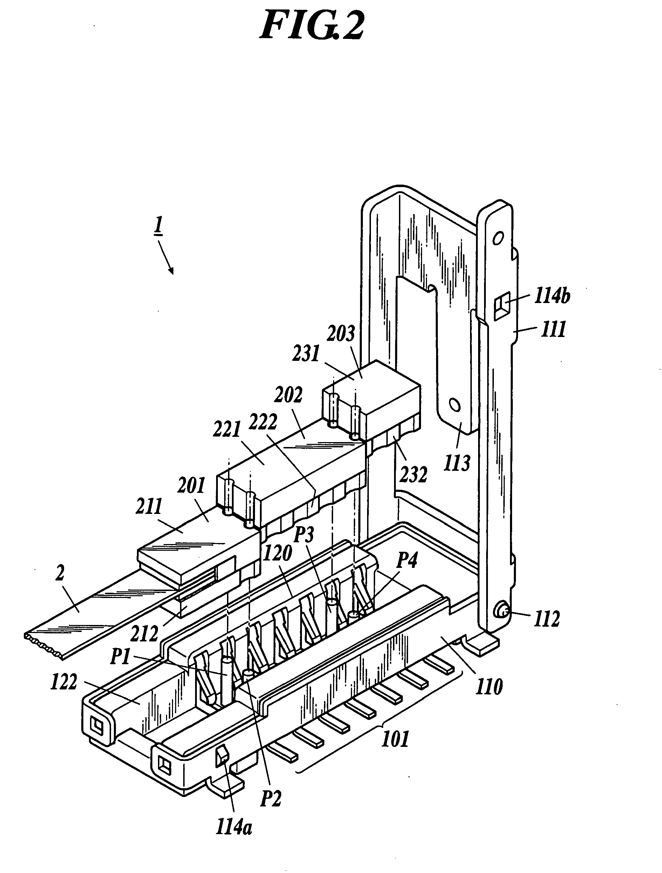

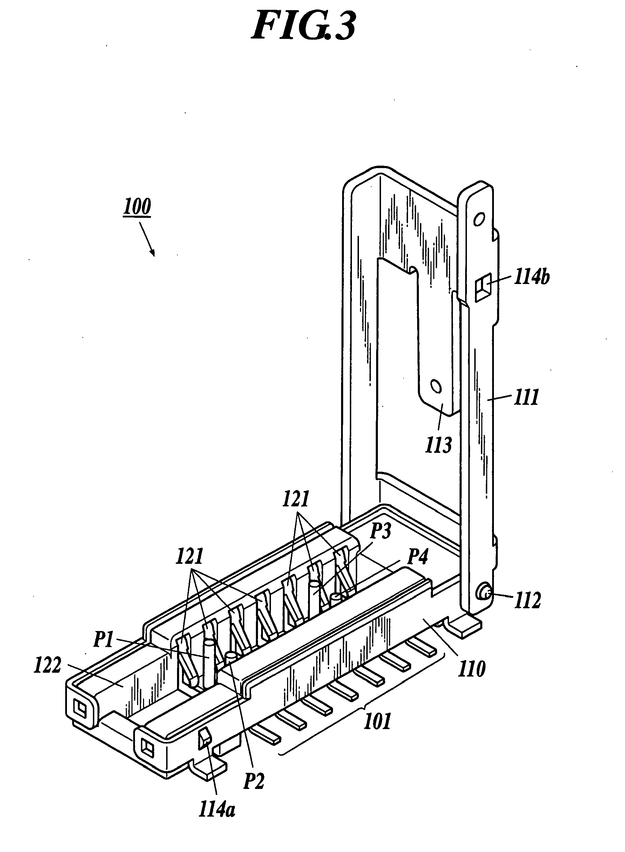

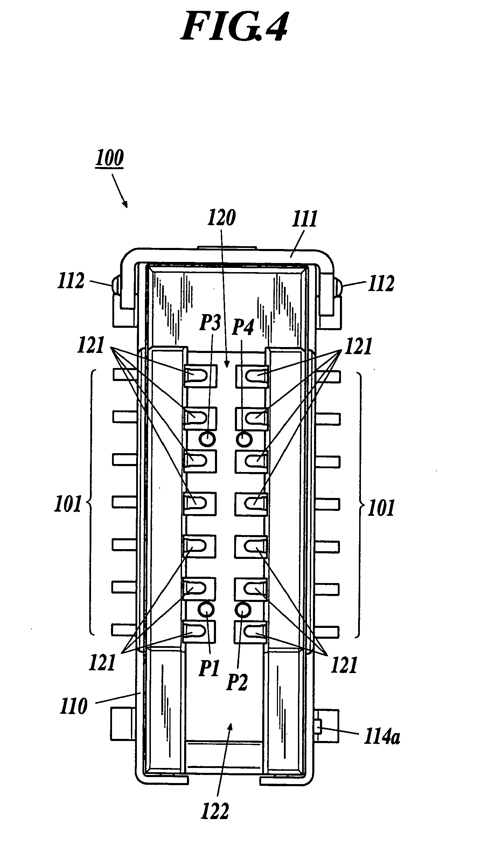

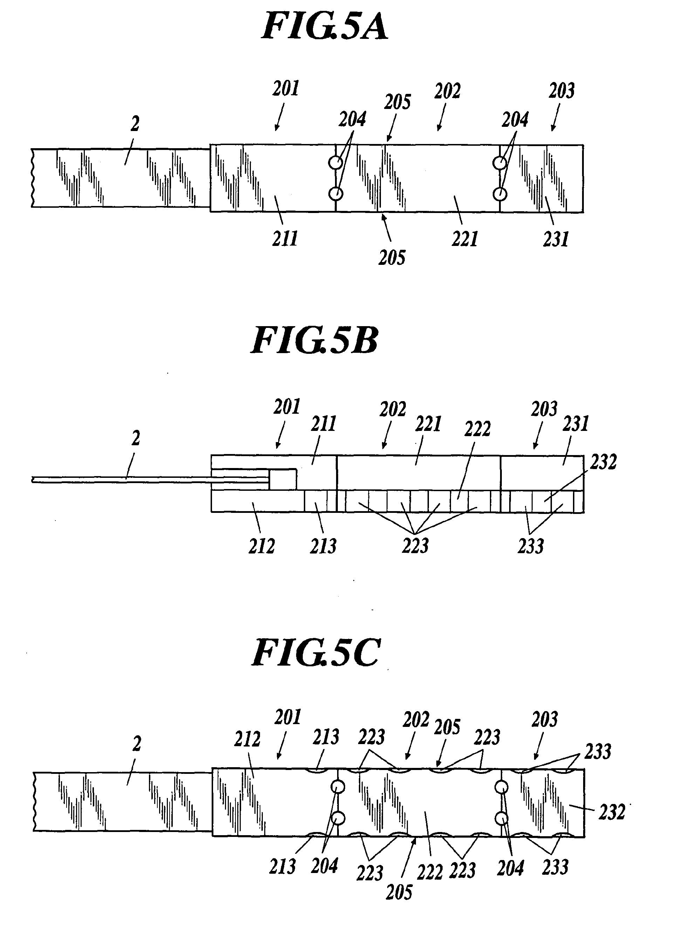

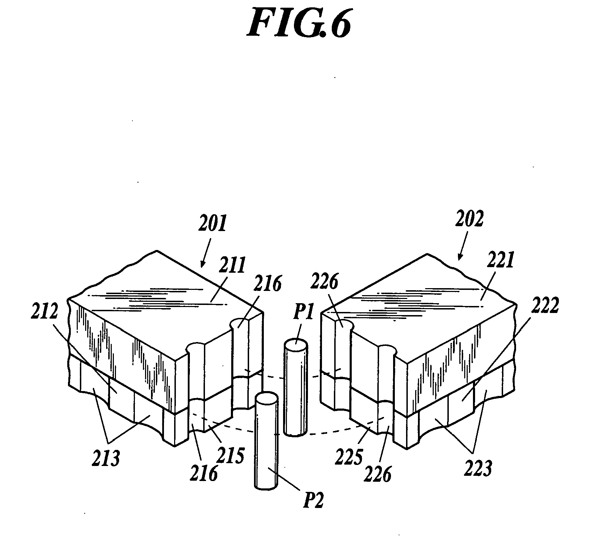

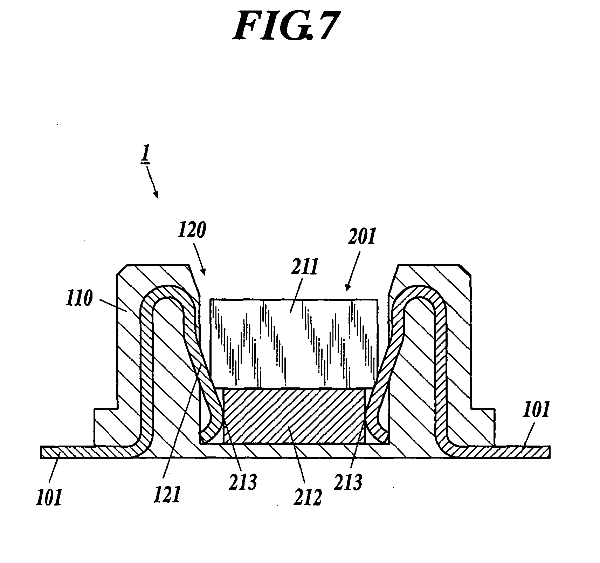

Fig. 1A illustrates a connection between electric-optic conversion modules 1 through an optical waveguide 2. Fig. 1B illustrates a state in which a plurality of divided units are fitted in a connector 100 of an electric-optic conversion module 1. Fig. 2 shows an optical signal transmission and reception unit 201, an amplifying unit 202, and a communication control unit 203 being fitted into a fitting section 120. Fig. 3 illustrates an external perspective view of the connector 100 with a cover member 111 lifted. Fig. 4 illustrates a top view of the connector 100 with the cover member 111 is lifted. Fig. 5A illustrates a top schematic diagram of a connection among a plurality of divided units. Fig. 5B illustrates a side schematic diagram of the connection among the plurality of divided units. Fig. 5C illustrates a bottom schematic diagram of the connection among the plurality of divided units. Fig. 6 illustrates a connection between the optical signal transmission and reception unit 201 and the amplifying unit 202. Fig. 7 shows a schematic sectional view of a state in which the optical signal transmission and reception unit 201 is fitted into the fitting section 120.

As shown in Fig. 1A, the electric-optic conversionmodule 1 transmits an optical signal to another electric-optic conversion module 1 through the optical waveguide 2. The electric-optic conversion module 1 is electrically connected to an external device through electrode portions 101 exposed to the outside. In the optical waveguide 2, two cores are covered with cladding when the optical transmission is performed bi-directionally or in parallel (a plurality of uni-directions), or one core is covered with cladding when the optical transmission is uni-directionally performed. The optical waveguide 2 has flexibility and is formed into a film shape.

As shown in Fig. 1B, in the electric-optic conversion module 1, a plurality of divided units such as the optical signal transmission and reception unit 201, the amplifying unit 202, and the communication control unit 203 are fitted into a connector main body 110 of the connector 100, and the upper portion of the fitted plurality of divided units is to be covered with the cover member 111.

The optical signal transmission and reception unit 201 includes a light receiving element such as a photo diode connected to the optical waveguide 2, and a light emitting element such as a laser diode connected to the optical waveguide 2. The optical signal transmission and reception unit 201 outputs an electric signal to the amplifying unit 202 based on an optical signal propagating through the optical waveguide 2, and outputs an optical signal to the optical waveguide 2 according to an electric signal inputted from the amplifying unit 202. The amplifying unit 202 includes an amplifying element such as a transistor which amplifies an electric signal. The amplifying unit 202 amplifies the electric signal supplied from the optical signal transmission and reception unit 201 or the electric signal to be outputted to the optical signal transmission and reception unit 201. The communication control unit 203 includes a control IC (Integrated Circuit) and the like. In the optical signal transmission and reception unit 201 and amplifying unit 202, the communication control unit 203 controls the output of the electric signal into which the optical signal transmitted through the optical waveguide 2 is converted and the output of the optical signal to the optical waveguide 2 according to the electric signal supplied from the outside through the electrode portions 101.

The plurality of divided units (the optical signal transmission and reception unit 201, amplifying unit 202, and communication control unit 203) are divided from each other according to functions or combination of the respective functions. The optical signal transmission and reception unit 201, amplifying unit 202, and communication control unit 203 may freely be arranged. For example, a single unit having functions of the amplifying unit 202 and communication control unit 203 may be provided.

As shown in Figs. 2 and 3, the plurality of divided units such as the optical signal transmission and reception unit 201, the amplifying unit 202, and the communication control unit 203 are brought into contact with a wall surface by pushing the divided units in a bottom direction of the fitting section 120 provided in the connector main body 110. Thus, the divided units are fitted into the connector main body 110. The fitting section 120 includes socket contact portions 121 on both wall surfaces in a longitudinal direction (extended direction of the optical waveguide 2 when the optical signal transmission and reception unit 201 is connected) of the fitting section 120. The socket contact portions 121 are in contact with electrode terminals exposed outside the divided units when the divided units are fitted into the connector main body 110. An opening 122 for guiding the extending optical waveguide 2 to the outside is provided at the side of the optical signal transmission and reception unit 201 in a transverse direction of the fitting section 120. The transverse direction is orthogonal to the longitudinal direction.

As shown in Figs. 2 to 4, the fitting section 120 includes pins P1 to P4 projecting toward a direction opposite to a fitting direction of the divided units from a bottom face to which the plurality of divided units are connected when the divided units are in contact with socket contact portions 121 and fitted into the fitting section 120. The pins P1 to P4 are provided for defining the fitting positions of the plurality of divided units in the longitudinal direction. The pins P1 to P4 are made of metal having conductivity, and are substantially cylindrically-shaped. The pins P1 to P4 are electrically connected to recessed portions of the divided units described later. The shapes of the pins P1 to P4 are not limited to the substantially cylindrical shapes, but the pins P1 to P4 may be formed into plate shapes or polygonal shapes.

As shown in Figs. 2 to 4, the connector main body 110 is provided with the cover member 111 capable of turning around a shaft portion 112. The cover member 111 includes a pressing portion 113. When the optical signal transmission and reception unit 201, the amplifying unit 202, and the communication control unit 203 are fitted into the fitting section 120, these units are pressed by the pressing member 113, which is rotated around the shaft portion 112 toward the fitting section 120, in a bottom direction of the fitting section 120 to fix these units in the fitting section 120. A pawl 114a and a pawl socket 114b are provided in the connector main body 110 and the cover member 111, respectively. The pawl 114a and the pawl socket 114b are used to fix the cover member 111 with the divided units pressed in the bottom direction of the fitting section 120.

The divided units include boards inside thereof (not shown). The boards transmit and receive the optical signal, convert the optical signal into the electric signal, and perform the control thereof. As shown in Figs. 5A, 5B and 5C, upper portions of the optical signal transmission and reception unit 201, amplifying unit 202, and communication control unit 203, which are fitted in the fitting section 120, are covered with upper cases 211, 221, and 231, respectively, and lower portions of the divided units are covered with lower cases 212, 222, and 232, respectively.

Connecting terminals 213, 223, and 233 are provided on side faces 205 of the lowercases 212, 222, and232, respectively. The connecting terminals 213, 223, and 233 electrically connected to the boards provided inside the divided units, and are in contact with the socket contact portions 121 when the divided units are fitted into the fitting section 120. Pin receiving holes 204 are formed in a connection part between the optical signal transmission and reception unit 201 and the amplifying unit 202, and in a connection part between the amplifying unit 202 and the communication control unit 203. The pins are inserted into the pin receiving holes 204 when the divided units are fitted into the fitting section 120.

As shown in Fig. 6, for example, with respect to the connection part between the optical signal transmission and reception unit 201 and the amplifying unit 202, recessed portions 216 and 226 are formed on connecting surfaces 215 and 225 of the optical signal transmission and reception unit 201 and the amplifying unit 202, respectively. Each of the recessed portions 216 and 226 is substantially cylindrically-shaped with a radius of the pin. The pin receiving holes 204 are formed by the recessed portions 216 and 226. The recessed portions 216 and 226 constituting the pin receiving holes 204 are made of metal which is electrically connected to the boards provided inside the divided units, and the recessed portions 216 and 226 are elastically deformed to contact the pins P1 and P2. Therefore, the electrical connection between the optical signal transmission and reception unit 201 and the amplifying unit 202 is established by the recessed portions 216 and 226 through the pins P1 and P2. The same holds true for the connection between other divided units.

Each of the socket contact portions 121, which are in contact with the optical signal transmission and reception unit 201, the amplifying unit 202, and the communication control unit 203 when these divided units are fitted into the fitting section 120, is made of conductive elastic metal material and is in the form of a long plate. As shown in Fig. 7, each of the socket contact portions 121 is bent in the connector main body 110, extended in substantially parallel with the bottom of the connector 100 from the end of the bottom, and exposed to the outside as the electrode portion 101.

For example, the socket contact portions 121 are in contact with the connecting terminals 213 with the socket contact portions 121 elastically deformed as shown in Fig. 7 when the optical signal transmission and reception unit 201 is fitted into the fitting section 120. Therefore, the socket contact portions 121 are in contact with the connecting terminals 213 with the socket contact portions 121 biased toward the optical signal transmission and reception unit 201 from both side surfaces in the longitudinal direction of the fitting section 120. Thus, the optical signal transmission and reception unit 201 is fixed in the fitting section 120. The socket contact portions 121 are in contact with the connecting terminals 213 with certainty so that the electrical connection between the external device and the optical signal transmission and reception unit 201 can be established through the electrode portions 101.

Thus, in the electric-optic conversion module 1, the plurality of divided units such as the optical signal transmission and reception unit 201, the amplifying unit 202, and the communication control unit 203 which convert the optical signal propagating through the optical waveguide 2 into the electric signal and convert the electric signal into the optical signal to output the optical signal to the optical waveguide 2, are fitted into the fitting section 120 of the connector main body 110 under the condition that electrode portions of the divided units are in contact with the socket contact portions 121 which are connected to the electrode portions 101 exposed to the outside.

With this structure, in the electric-optic conversion module 1, when replacement of one of the divided units is required because of replacement of a part of the electronic components, only the target divided unit can be replaced, so that the divided unit (electronic components) can be replaced at less cost.

The electric-optic conversion module 1 includes the pins P1 to P4 for defining the connection positions of the divided units such as the optical signal transmission and reception unit 201, the amplifying unit 202, and the communication control unit 203 when the divided units are fitted into the fitting section 120, and the divided units have the recessed portions which receive the pins P1 to P4. With this structure, the plurality of divided units fitted into the fitting section 120 can accurately be positioned.

Moreover, in the electric-optic conversion module 1, since the conductive pins P1 to P4 and the recessed portions as electrical terminals connected to the inside boards can be in contact with each other, the electrical connection between the adjacent divided units can be established.

### [First Modification]

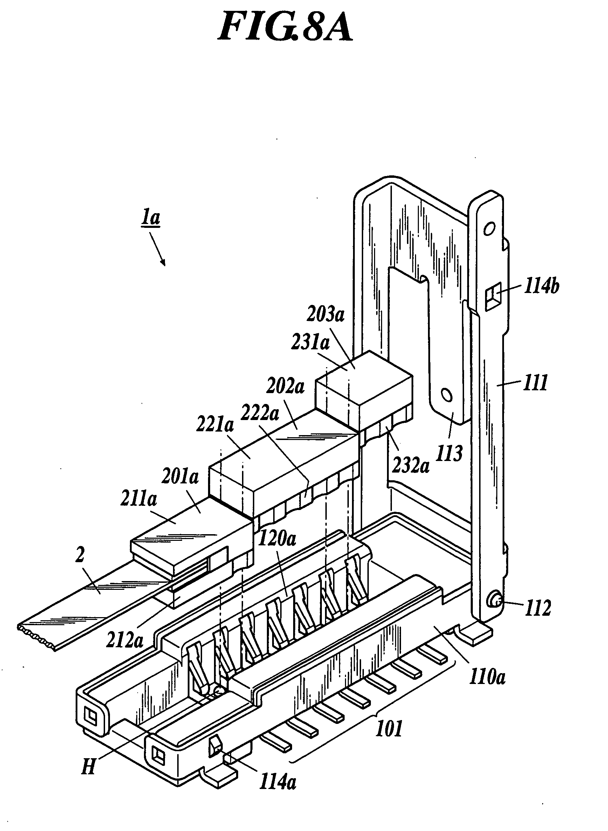

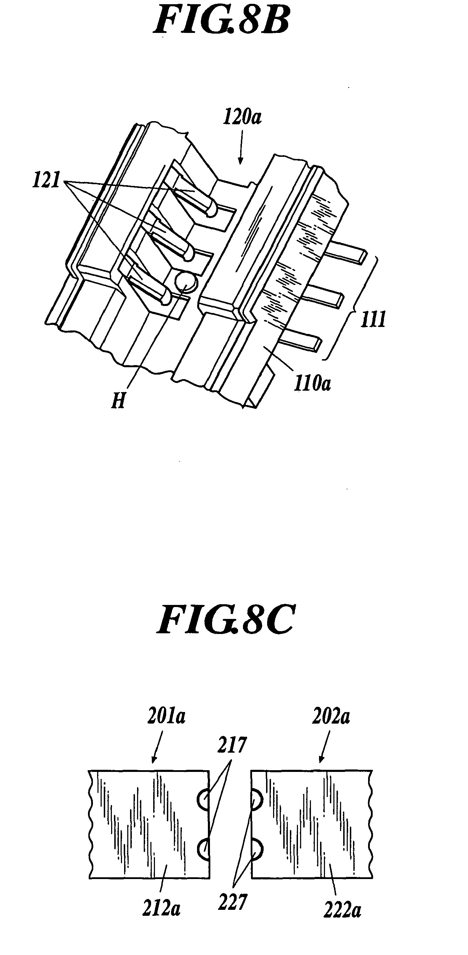

Next, an electric-optic conversion module 1a as a modification of the electric-optic conversion module 1 will be described with reference to Figs. 8A, 8B and 8C. Fig. 8A shows divided units being fitted into a fitting section of an electric-optic conversion module 1a according to the first modification. Fig. 8B illustrates a conductive bump H provided in the fitting section 120a. Fig. 8C illustrates a bottom of a connection part between an optical signal transmission and reception unit 201a and an amplifying unit 202a. In Figs. 8A to 8C, the same reference numerals are given without adding explanations for those configurations that are the same as the above-described electric-optic conversion module 1.

As shown in Fig. 8A, the electric-optic conversion module 1a is provided with a fitting section 120a in a connector main body 110a. An optical signal transmission and reception unit 201a, an amplifying unit 202a, and a communication control unit 203a are fitted into the fitting section 120a. As shown in Figs. 8A and 8B, the fitting section 120a includes conductive bumps H projecting toward a direction opposite to the fitting direction of the divided units from a bottom face to which the plurality of divided units are connected when the divided units are in contact with socket contact portions 121 and fitted into the fitting section 120a. For example, a solder bump may be employed as the conductive bump H.

Recessed portions (bottom connection portions) for connecting the conductive bumps H are provided on bottom faces (see an alternate long and short dash line of Fig. 8A) of the optical signal transmission and reception unit 201a, the amplifying unit 202a, and the communication control unit 203a. The recessed portions are portions in which the divided units are in contact with each other and which are in contact with the conductive bump H when the divided units are fitted into the fitting section 120a.

Specifically, as shown in Fig. 8C, bottom connection portions 217 and 227, which are electrically connected to the boards provided inside, are provided on lower cases 212a and 222a of the optical signal transmission and reception unit 201a and the amplifying unit 202a, respectively. The bottom connection portions 217 and 227 are provided near positions at which the divided units are in contact with each other with the divided units fitted in the fitting section 120a, and are provided at bottom positions connected to the conductive bumps H. When the optical signal transmission and reception unit 201a and the amplifying unit 202a are fitted into the fitting section 120a, the optical signal transmission and reception unit 201a and the amplifying unit 202a are electrically connected to each other through the bottom connection portions 217 and 227 and the conductive bumps H. The same holds true for the connection between other divided units.

As described above, the electric-optic conversion module 1a is provided with the conductive bumps H on the bottom of the fitting section 120a, and the divided units such as the optical signal transmission and reception unit 201a, the amplifying unit 202a, and the communication control unit 203a are fixed by the conductive bumps H when these units are fitted into the fitting section 120a. With this structure, the divided units can be fixed with certainty in the electric-optic conversion module 1a.

The connection portions of the divided units are connected to the conductive bumps H, and are electrically connected to the boards in the divided units, so that the divided units contacting each other can be electrically connected through the conductive bumps H.

### [Second Modification]

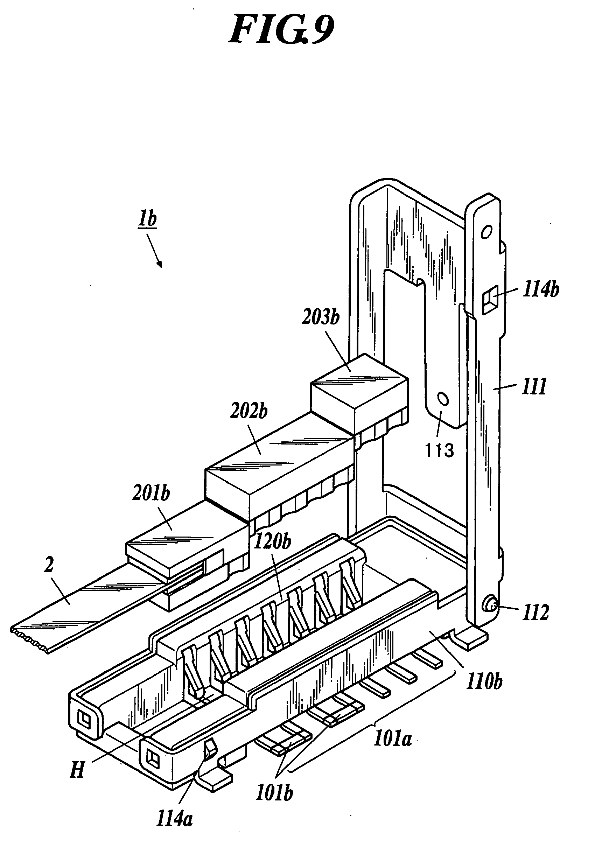

Next, an electric-optic conversion module 1b as a modification of the electric-optic conversion module 1 will be described with reference to Fig. 9. Fig. 9 shows divided units being fitted into a fitting section of an electric-optic conversion module 1b according to the second modification. In Fig. 9, the same reference numerals are given without adding explanations for those configurations that are the same as the above-described electric-optic conversion module 1.

As shown in Fig. 9, the electric-optic conversion module 1b is provided with a fitting section 120b in a connector main body 110b. An optical signal transmission and reception unit 201b, an amplifying unit 202b, and a communication control unit 203bare fitted into the fitting section 120b. The divided units may be fixed in the fitting section 120b using the pins or the conductive bumps described above, or the divided units maybe fixed in the fitting section 120b only through the contact with the socket contact portions 121.

As with the electrode portions 101 described above, each of electrode portions 101a is made of conductive elastic metal material and is in the form of a long plate. The electrode portions 101a are bent in a connector main body 110b to form the socket contact portions 121 of the fitting section 120b. The electrode portions 101a are exposed to the outside of the electric-optic conversion module 1. One electrode portion 101a is connected to another electrode portion 101a at the ends thereof through a conductive interelectrode connection section 101b.

With this structure, in the electric-optic conversion module 1b, the terminals can electrically be connected to each other in the socket contact portions 121 through the interelectrode connection sections 101b of the electrode portions 101a exposed to the outside. That is, the optical signal transmission and reception unit 201b, the amplifying unit 202b, and the communication control unit 203b, which are fitted into the fitting section 120b, can electrically be connected to each other with ease through the interelectrode connection sections 101b with the divided units fitted into the connector main body 110b.

### [Third Modification]

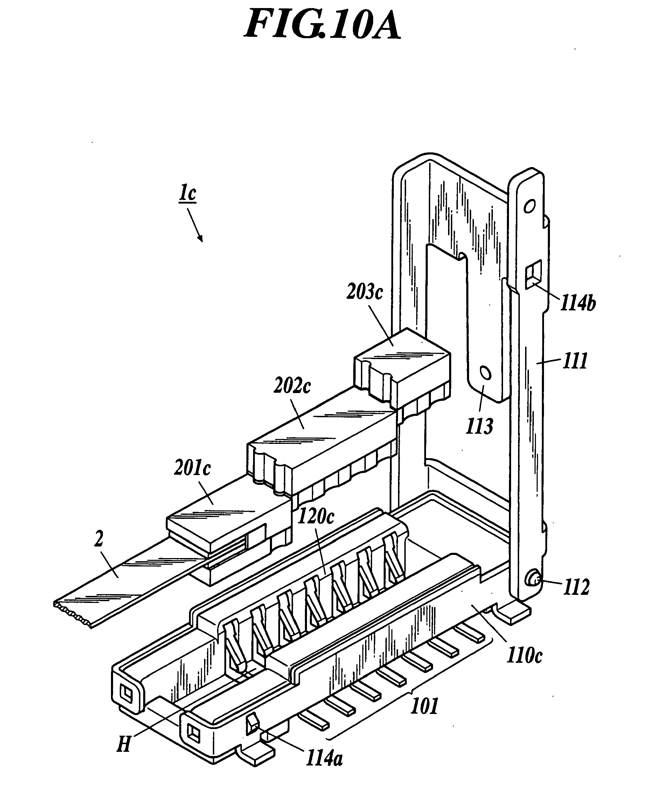

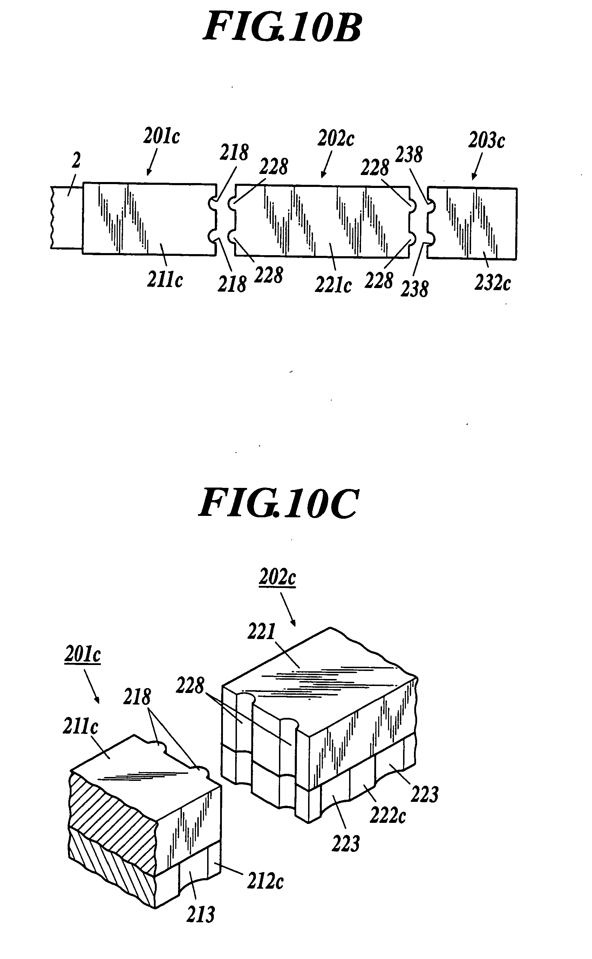

Next, an electric-optic conversion module 1c as a modification of the electric-optic conversion module 1 will be described with reference to Figs. 10A, 10B and 10C. Fig. 10A shows divided units being fitted into a fitting section of the electric-optic conversion module 1c according to a third modification. Fig. 10B illustrates a top view of an optical signal transmission and reception unit 201c, an amplifying unit 202c, and a communication control unit 203c. Fig. 10C illustrates a connection portion between the optical signal transmission and reception unit 201c and the communication control unit 202c. In Figs. 10A to 10C, the same reference numerals are given without adding explanations for those configurations that are the same as the above-described electric-optic conversion module 1.

As shown in Fig. 10A, the electric-optic conversion module 1c is provided with a fitting section 120c in a connector main body 110c. The optical signal transmission and reception unit 201c, the amplifying unit 202c, and the communication control unit 203c are fitted into the fitting section 120c. The divided units are fixed in the fitting section 120c only through the contact with the socket contact portion 121.

As shown in Fig. 10B, the optical signal transmission and reception unit 201c, the amplifying unit 202c, and the communication control unit 203c include member connection portions 218, 228, and238, respectively which are electrically connected to the boards provided inside. The member connection portions 218, 228, and 238 are provided on faces on which the divided units are in contact with each other when the divided units are fitted into the fitting section 120c. The member connection portions 218, 228, and 238 are recessed portions and/or projection portions which are fitted into each other.

Specifically, as shown in Fig. 10C, the optical signal transmission and reception unit 201c is provided with the member connection portion 218 having the projected shape on the face on which the optical signal transmission and reception unit 201c is in contact with the amplifying unit 202c. The amplifying unit 202c is provided with the member connection portion 228 having the recessed shape on the face on which the amplifying unit 202c is in contact with the optical signal transmission and reception unit 201c. In fitting into the fitting section 120c, the member connection portions 218 and 228 are fitted into each other to connect the optical signal transmission and reception unit 201c and the amplifying unit 202c. The same holds true for the connection between other divided units.

With this structure, in the electric-optic conversion module 1c, when the optical signal transmission and reception unit 201c, the amplifying unit 202c, and the communication control unit 203c are fitted into the fitting section 120c, the divided units can be connected to each other with certainty, and the adjacent divided units can electrically be connected to each other.

The description of the embodiments is exemplary, and the present invention is not limited to the embodiments. Various modifications and changes can appropriately be made in the detailed configurations of the electric-optic conversion modules 1, 1a, 1b, and 1c of the embodiments.

### Industrial Applicability

An electric-optic conversion module of the present invention is applicable in the optical communications field.

### Description of Reference Numerals

1, 1a, 1b and 1c electric-optic conversion module
2 optical waveguide
100 connector
101 electrode portion
101a electrode portion
101b interelectrode connection section
110, 110a, 110b and 110c connector main body
111 cover member
112 shaft portion
113 pressing portion
114a pawl
114b pawl socket
120, 120a, 120b and 120c fitting section
121 socket contact portion
122 opening
201, 201a, 201b and 201c optical signal transmission and reception unit
202, 202a, 202b and 202c amplifying unit
203, 203a, 203b and 203c communication control unit
204 pin receiving hole
205 side face
211, 211a, 211b and 211c upper case
212, 212a, 212b and 212c lower case
213 connecting terminal
215 connection surface
216 recessed portion
217 bottom connection portion
218 member connection portion
221, 221a, 221b and 221c upper case
222, 222a, 222b and 222c lower case
223 connecting terminal
225 connection surface
226 recessed portion
227 bottom connection portion
228 member connection portion
231, 231a, 231b and 231c upper case
232, 232a, 232b and 232c lower case
233 connecting terminal
238 member connection portion
P1 to P4 pin
H conductive bump

## Claims

1. An electric-optic conversion module comprising:
a functional section including an optoelectric conversion element and an auxiliary element of the optoelectric conversion element; and
a connector which accommodates the functional section to electrically connect the functional section and an external device, wherein
the functional section comprises a plurality of divided units which are divided from one another according to functions or combination of the respective functions and which are removable from one another and removable from the connector.

2. The electric-optic conversion module according to claim 1, wherein each of the plurality of divided units is accommodated in the connector through a positioning section for defining an accommodation position of each of the divided units in the connector.

3. The electric-optic conversion module according to claim 2, wherein the positioning section is formed by combination of a projection portion and a recessed portion, the projection portion being provided in an accommodation section of the connector and projecting toward a direction opposite to a fitting direction of the divided units, each of the divided units being provided with the recessed portion on a boundary surface with the adjacent divided unit, the projection portion being fitted into the recessed portion.

4. The electric-optic conversion module according to claim 3, wherein the projection portion is a conductive pin having a columnar shape, and the recessed portion is provided with a conductive portion which is in electrically contact with the conductive pin.

5. The electric-optic conversion module according to claim 3, wherein the projection portion is a conductive bump, and the recessed portion is provided with a conductive portion which is in electrically contact with the conductive pin.

6. The electric-optic conversion module according to claim 2, wherein the positioning section is formed by combination of a projection portion and a recessed portion, the projection portion and the recessed portion being respectively provided on faces, which are opposed to one another, of the adjacent divided units accommodated in the connector, the projection portion and the recessed portion being fitted into one another.

7. The electric-optic conversion module according to claim 6, wherein the projection portion and the recessed portion are respectively provided with different conductive portions which are in electrically contact with one another.

8. The electric-optic conversion module according to claim 1, wherein the connector is provided with conductive connecting terminals which are extended outward and which are in electrically contact with the divided units, and the divided units are electrically connected to one another by electrically connecting the connecting terminals.

9. The electric-optic conversion module according to any one of claims 1 to 8, wherein an optical waveguide is optically connected to the optoelectric conversion element of the functional section.
